(19) Europäisches Patentamt European Patent Office Office européen des brevets

(11) **EP 2 409 132 B1**

(12) **FASCICULE DE BREVET EUROPEEN**

(45) Date de publication et mention de la délivrance du brevet:
**22.05.2019 Bulletin 2019/21**

(21) Numéro de dépôt: **10712454.7**

(22) Date de dépôt: **12.03.2010**

(51) Int Cl.:
*G01N 15/02* (2006.01)    *G01N 15/06* (2006.01)
*H01J 37/00* (2006.01)    *H01J 37/32* (2006.01)
*H05H 1/00* (2006.01)

(86) Numéro de dépôt international:
**PCT/FR2010/000207**

(87) Numéro de publication internationale:
**WO 2010/106240 (23.09.2010 Gazette 2010/38)**

(54) **PROCEDE DE DETERMINATION DU RAYON SURFACIQUE ET/OU DE LA DENSITE PARTICULAIRE D'UNE POUDRE**

VERFAHREN ZUR BESTIMMUNG DES OBERFLÄCHENRADIUS UND/ODER DER TEILCHENDICHTE EINES PULVERS

METHOD FOR DETERMINING THE SURFACE RADIUS AND/OR PARTICLE DENSITY OF A POWDER

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **17.03.2009 FR 0901240**

(43) Date de publication de la demande:
**25.01.2012 Bulletin 2012/04**

(73) Titulaires:
 • **Centre National de la Recherche Scientifique**
 **75016 Paris (FR)**
 • **Université d'Orléans**
 **45067 Orléans Cedex 2 (FR)**

(72) Inventeurs:
 • **BOUFENDI, Laïfa**
 **F-45560 Saint Denis en Val (FR)**
 • **WATTIEAUX, Gaëtan**
 **F-45000 Orléans (FR)**

(74) Mandataire: **Bréda, Jean-Marc**
 **Marks & Clerk France**
 **Immeuble Visium**
 **22, avenue Aristide Briand**
 **FR-94117 Arcueil Cedex (FR)**

(56) Documents cités:
 **WO-A-00/25109**

 • **BOUFENDI L ET AL: "Detection of particles of less than 5 nm in diameter formed in an argon-silane capacitively coupled radio-frequency discharge" APPLIED PHYSICS LETTERS, AIP, AMERICAN INSTITUTE OF PHYSICS, MELVILLE, NY, US, vol. 79, no. 26, 24 décembre 2001 (2001-12-24), pages 4301-4303, XP012029724 ISSN: 0003-6951 cité dans la demande**
 • **KAWAMURA E ET AL: "REVIEW ARTICLE; Ion energy distributions in rf sheaths; review, analysis and simulation" PLASMA SOURCES SCIENCE AND TECHNOLOGY, INSTITUTE OF PHYSICS PUBLISHING, BRISTOL, GB, vol. 8, no. 3, 1 août 1999 (1999-08-01), pages R45-R64, XP020070472 ISSN: 0963-0252 cité dans la demande**

## Description

La présente invention a pour objet la détermination du rayon surfacique moyen $r_D$ et/ou de la densité $n_D$ des particules d'une poudre, notamment d'une nanopoudre dans un plasma de volume V formé entre une première électrode alimentée par une tension radiofréquence et une deuxième électrode portée à une tension fixe notamment la masse.

Les développements sur les applications des nanomatériaux ne cessent de croître. Des rapports (comme celui de l'AFSSET 2006 [Rapport AFSETT - les nanomatériaux : effets sur la santé de l'homme et sur l'environnement - juillet 2006] en France par exemple) de commissions scientifiques montrent que l'économie des dix prochaines années sera fortement conditionnée par la production de nanomatériaux, tant ils touchent de nombreux domaines socio-économiques comme l'énergie, les matériaux pour l'énergie, le médical, l'électronique, la cosmétique, les matériaux composites pour ne citer que ces quelques exemples. Ces nanomatériaux vont apparaître sous des formes très variées qui dépendent fortement des technologies concernées. On peut les classer, selon M. C. Roco [M. C. Roco, "International perspective on government nanotechnology funding in 2005", J. Nanopart. Res. 7(6), 707 - 712, 2005], en quatre grands domaines qui sont :

1- Les nanostructures passives, qui regroupent les nanostructures dispersées et agglomérées (aérosols, colloïdes) et les matériaux incorporant des nanostrucutures (les enrobages, le renforcement des composites par nanoparticules, les métaux nanostrucutrés, les polymères, les céramiques, etc...)

2- Les nanostructures actives qui concernent celles qui sont bioactives et ayant des effets médicaux (ou sanitaires) (molécules portées et dirigées vers une cible identifiée, les bio-dispositifs...) et celles ayant une activité physico-chimique (transistors tridimensionnels, amplificateurs, actuateurs, structures adaptatives...).

3- Les nanosystèmes comme les ensembles guidés, les réseaux tridimensionnels et les architectures hiérarchiques, la robotique...

4- Les nanosystèmes moléculaires concernant les dispositifs moléculaires et atomiques, les fonctions émergentes...

La présence croissante de ces nanomatériaux dans tous les domaines de l'activité humaine amène légitimement à se poser des questions sur les retombées sanitaires et environnementales. Dans un article récent la revue « Technology Review » [-www.technologyreview.fr/nano-tech/?id=196], on fait état de problèmes de santé liés à l'utilisation de produits de la vie courante (nettoyant ménager par exemple), ce type d'articles ayant obtenu sans aucun doute toutes les autorisations sanitaires actuellement nécessaires avant leur lancement sur le marché. De même, les nanoparticules de carbone ont été montrées du doigt pour être responsable de pathologies sur le nerf optique de la souris [Oberdörster G, Oberdörster E, Oberdörster J. Concepts of nanoparticle dose metric and response metric. Environ Health Perspect. 2007 Jun;115(6):A290] - (G. Oberdörster, université de Rochester). D'autres études ont mis en évidence des problèmes liés à la présence de fullerènes (E. Oberdörster, université de Duke) ou de nanotubes de carbone [Chiu-Wing Lam, John T. James, Richard McCluskey and Robert L. Hunter, Toxicological Sciences 77, 126-134 (2004).] (C.W. Lam, NASA, Houston). Régulièrement d'autres substances viennent s'ajouter à cette liste. Cela a bien sûr conduit à attirer l'attention sur la validité des critères de validation des produits et de leurs constituants élémentaires. Actuellement, la règle employée est le cas par cas, puisqu'il n'y a pas de méthodologie adaptée à la validation des nanomatériaux, ce qui pose un problème fondamental.

De plus, l'apparition de nanopoudres dans les plasmas utilisés dans les procédés de fabrication dans les industries de la microélectronique induit des défauts irrémédiables dans les dispositifs élaborés. Les taux de perte peuvent dépasser 50% dans certains secteurs. Cette situation concerne aussi les salles blanches, c'est à dire l'environnement immédiat des machines mais aussi des opérateurs, où les systèmes de mesures concernent des poudres en suspension dans l'air dont la taille est supérieure ou égale à 0,5 $\mu$m. Ainsi les besoins en matière de détection et de métrologie in-situ en phase gazeuse sont d'une grande importance.

La plupart des méthodes mises en oeuvre jusqu'à présents sont basées sur l'interaction d'un faisceau lumineux avec les poudres. Elles se déclinent sous diverses versions pour des mesures in-situ telles que la diffusion de la lumière (y compris les Lidars) et l'incandescence induite par laser. D'autres versions nécessitent la collecte d'échantillons qui sont mis en suspension dans une solution aqueuse pour des mesures ex-situ. Pour toutes les méthodes permettant des caractérisations in-situ, il nécessaire d'avoir des accès optiques dans les systèmes (réacteurs et autres) ce qui est loin d'être le cas dans la plus part des réacteurs industriels. De plus les sections efficaces de diffusion deviennent très faibles pour des poudres de tailles nanométriques et l'intensité de la lumière diffusée est complètement noyée dans le bruit. Par conséquent, afin d'effectuer des mesures fiables dans la gamme nanométrique des tailles de poudres, il est nécessaire de rechercher de nouvelles méthodes non-intrusives et ne nécessitant pas d'accès optique ou de prélèvements d'échantillons.

Sur le marché on retrouve beaucoup d'entreprises qui utilisent ces techniques optiques couplées parfois à des systèmes de charge des particules afin de les manipuler assez facilement. Ces techniques permettent par exemple de réaliser une ségrégation des particules par taille. Il n'est toutefois pas possible dans ce cas de répondre aux questions liées à la concentration de poudres où elles ont été prélevées. Parmi ces entreprises il est possible d'en citer quelques unes qui sont très actives sur ce marché :

- GRIMM (Allemagne)
- MALVERN (Grande-Bretagne)
- TSI (USA)
- NANOSIGHT (Grande-Bretagne)
- NANEUM (Grande-Bretagne)
- CILAS (France).

Les technologies développées par ces entreprises utilisent la diffusion (ou diffraction) de la lumière par les poudres en suspension dans une solution liquide où elles ont été préalablement immergées. Cette technique, avec ses diverses variantes telle que la diffusion dynamique de la lumière ("dynamic light scattering") présente néanmoins des limites liées à la section efficace de diffusion lorsque l'on s'intéresse à des particules dans la gamme nanométrique des tailles. En effet, en diffusion, l'intensité diffusée est proportionnelle à $r_p^6$ où $r_p$ est le rayon des particules de la poudre. Elle est par conséquent beaucoup plus sensible à la présence des agrégats.

Afin d'améliorer les performances, une autre méthode basée sur la mobilité des particules a été mise au point (TSI). Ce procédé, dénommé "Scanning Mobility Particle Sizer" (SMPS), permet de séparer les particules selon leur charge et leur mobilité électrique pour leur classification en taille. Les particules sont préalablement chargées par un procédé de décharge couronne. La technologie SMPS permet de mesurer des particules dans les aérosols avec des concentrations allant jusqu'à $10^7$ particules/cm$^3$.

Pour rendre cette technique plus sensible dans la gamme des tailles nanométriques, la compagnie Coulter, suivie de TSI, utilise l'effet de la condensation de la vapeur d'eau à la surface des nanoparticules pour les rendre plus "visibles" par diffusion de la lumière laser. Il est toutefois légitime à ce niveau de se poser la question suivante : mesure-t-on la taille de la particule "habillée" ou sa vraie taille ?

A travers les recherches menées au laboratoire GREMI depuis plus d'une quinzaine d'années sur la formation de nanoparticules dans les plasmas froids basses pressions, il a été montré que l'on peut utiliser les modifications des propriétés de la décharge induites par les poudres comme moyen de détection. On se reportera à ce sujet à la publication de L. BOUFENDI, et collaborateurs, intitulée "Détection of particles of less than 5 nm in diameter formed in an argon-silane capacitivily coupled radio-frequency discharge" (Applied physics letters - volume 79 n° 26 - 24 December 2001).

Depuis, quelques équipes de recherche à travers le monde ont utilisé cette méthode dans leurs travaux. Aucun groupe de recherche n'a utilisé cette démarche pour la mesure in situ et en temps réel de la taille et de la concentration de particules de poudre qui se forment et restent piégées en lévitation dans un plasma.

La présente invention a pour object un procédé qui permette de déterminer la valeur des paramètres (rayon surfacique) $r_D$ et/ou (densité particulaire) $n_D$ d'une nanopoudre en lévitation dans un plasma en mesurant l'amplitude d'une tension radiofréquence générant le plasma et la valeur de la tension d'autopolarisation d'une première électrode alimentée par la tension radiofréquence.

L'invention concerne ainsi un procédé de détermination du rayon surfacique $r_D$ et/ou de la densité particulaire $n_D$ d'une poudre dans un échantillon en lévitation dans un plasma électropositif de volume V formé entre une première électrode alimentée par une tension radiofréquence et une deuxième électrode portée à une tension fixe, notamment de masse, caractérisé en ce que :

$$n_D = \frac{1}{4\pi K^2 V \Delta A_B} \times \left( \frac{1}{V_{RF}} - \frac{1}{V_{RF(0)}} \right)^{2n}$$

$$r_D = K \frac{\Delta A_B}{\left( \dfrac{1}{V_{RF}} - \dfrac{1}{V_{RF(0)}} \right)^n}$$

$$K = \frac{\varepsilon_0 C}{q\, V\, D^n}, \quad \Delta A_B = \frac{\dfrac{\delta(t)}{\delta(0)} - 1}{\dfrac{1}{A_{M0}} + \dfrac{1}{A_{B0}}}, \quad \delta(t) = \frac{\pi}{arccos\left(\dfrac{V_{DC}}{V_{RF}}\right)} - 1$$

Avec : et

$$\delta(0) = \frac{\pi}{arccos\left(\dfrac{V_{DC(0)}}{V_{RF(0)}}\right)} - 1$$

$V_{RF}$ désigne l'amplitude à l'instant de mesure t de la tension radiofréquence RF alimentant la première électrode lorsque la poudre est présente dans le plasma, où l'instant t=0 correspond à l'absence de poudre dans le plasma,

$V_{RF(0)}$ désigne l'amplitude de ladite tension radiofréquence alimentant la première électrode en l'absence de poudre dans le plasma,

$V_{DC}$ désignant la tension d'autopolarisation de la première électrode à l'instant t lorsque la poudre est présente dans le plasma,

$V_{DC(0)}$ désignant la tension d'autopolarisation de la première électrode en l'absence de poudre dans le pasma,

$\Delta A_B$ désignant la variation de surface effective de la deuxième électrode en présence de poudre à l'instant t par rapport à une situation en l'absence de poudre, $A_{B0}$ et $A_{M0}$ désignant la surface effective des électrodes en l'absence de poudre,

et les valeurs de n et de K étant déterminées par étalonnage en traçant une courbe donnant $r_D$ en fonction de $\Delta A_B$ et de $V_{RF}$ à partir de données expérimentales obtenues à partir de poudres ayant un diamètre de particules connu en mesurant $V_{RF}$, $V_{RF(0)}$, $V_{DC}$, et $V_{DC(0)}$ et en réalisant une régression sur ladite courbe,

$\alpha$ désigne la surface caractéristique de la décharge avec $A_B + A_M = \alpha\Pi$

$A_B$ et $A_M$ étant des surfaces caractéristiques des électrodes $\alpha = r^2_B + r^2_M$.

Le plasma peut être un plasma électropositif ou un plasma d'air. La première et la deuxième électrodes peuvent faire partie d'une installation préexistante, ou bien être disposées dans une cellule de mesure pourvue d'un moyen d'aspiration.

L'invention concerne également un dispositif pour la mise en oeuvre du procédé, comportant :

- un générateur radio fréquence alimentant une première et une deuxième électrodes pour générer un dit plasma dans un volume V, compris entre lesdites électrodes,

caractérisé en ce que le dispositif comporte en outre :

- un dispositif de mesure de la tension radiofréquence $V_{RF}$ et de la tension d'autopolarisation $V_{DC}$.

L'invention sera mieux comprise à la lecture de la description ci-après en liaison avec les dessins annexés dans lesquels :

- la figure 1 est un schéma d'un dispositif pour la mise en oeuvre de l'invention,
- les figures 2 et 3 illustrent l'évolution de la tension d'autopolarisation et de la densité électronique durant la croissance d'une nanopoudre dans un plasma froid basse pression (figure 2), et sa corrélation avec l'amplitude de la 3ème harmonique du courant de décharge (figure 3)

- la figure 4 illustre l'évolution temporelle de l'amplitude crête à crête $V_{RF}$ de la tension d'excitation RF durant la formation d'une nanopoudre

- la figure 5 illustre le contrôle de la synthèse d'une nanopoudre par la tension d'auto-polarisation ($V_{DC}$) et l'intensité du courant de décharge

- la figure 6 est une photographie de nanoparticules d'une nanopoudre formée dans un plasma

- la figure 7 illustre la relation entre $\phi$, $n_i - n_e$ et la variation de la température électronique en présence de particules ou d'agglomérats de particules de poudre

- les figures 8 à 8c illustrent la relation $V_{RF}$ x $T_e$ = constante lors de la croissance d'une nanopoudre

- la figure 9 montre la relation entre $r_D$ linéarisé connu et $r_D$ calculé ainsi déterminée par calcul, exprimés en mètres

- les figures 10 et 11 illustrent la relation entre le rayon (en nm) des poudres $r_D$ connu et déterminé par calcul et de la densité particulière mesurée directement et estimée par le calcul

- et la figure 12 est un mode de réalisation préféré d'un dispositif de mesure des tensions radio-fréquence $V_{RF}$ et/ou d'autopolarisation $V_{DC}$.

Les termes utilisés dans la suite de la description sont énumérés ci-après.

| Abréviation | Définition |
|---|---|
| $V_{DC}$ | tension d'autopolarisation de l'électrode B reliée à la sortie de la boîte d'accord (valeur moyenne du potentiel de l'électrode par rapport à la masse) en présence de poudre et $V_{DC(0)}$ en l'absence de poudre |
| $V_{RF}$ | amplitude à un instant t de la tension radiofréquence RF alimentant l'électrode B reliée à la sortie de la boîte d'accord, en présence de poudre et $V_{RF(0)}$ en l'absence de poudre |
| $A_B$ | surface effective d'échange de charges électriques entre le plasma et l'électrode B reliée à la sortie de la boîte d'accord |
| $A_M$ | surface effective d'échange de charges électriques entre le plasma et l'électrode M reliée à la masse |
| $\delta(t) = \dfrac{A_B}{A_M}$ | $\delta(0) = \dfrac{A_{B0}}{A_{M0}}$ désignant ce rapport rapport des surfaces effectives des électrodes à l'instant t en l'absence de poudre |
| $\alpha$ | surface caractéristique de la décharge |
| $\Delta A_B$ | variation de la surface effective d'échange de charges électriques entre le plasma et l'électrode B reliée à la sortie de la boîte d'accord en présence de poudre au sein du plasma par rapport à une situation d'absence de poudre |
| $\Delta A_M$ | variation de la surface effective d'échange de charges électriques entre le plasma et l'électrode M reliée à la masse en présence de poudre au sein du plasma par rapport à une situation d'absence de poudre |
| $r_D$ | rayon surfacique des particules piégées dans le plasma (c'est le rayon d'une sphère ayant la même surface qu'une particule de la poudre constituant l'échantillon analysé) ; il est calculé sous forme d'une moyenne selon la formule donnée ci-après |
| $n_D$ | densité particulaire ou concentration de la poudre constituant l'échantillon analysé au sein du plasma (exprimé en $10^{15}$ particules/cm$^3$) |
| $V$ | volume occupé par le plasma |
| $n_i$ | densité ionique du plasma |
| $n_e$ | densité électronique du plasma |
| $Z_D$ | nombre de charges élémentaires fixées sur une particule de la poudre |
| $T_e$ | température électronique moyenne au sein du plasma |
| $\Phi$ | différence de potentiel entre la surface de chaque particule de la poudre et le plasma |
| $\varepsilon_0$ | permittivité du vide (8,85.10$^{-12}$ F/m) |
| $q$ | charge élémentaire (1,6.10$^{-19}$ C) |

L'invention s'applique plus particulièrement au cas d'un plasma froid (c'est-à-dire kTe ≤ 10 eV, k étant la constante de Boltzman) basse pression (c'est-à-dire à une pression P < 1mbar).

Le plasma peut être aussi bien un plasma électropositif (par exemple plasma d'argon) qu'un plasma d'air, puisque la méthode de mesure, comme il apparaîtra dans la suite de la description, est différentielle.

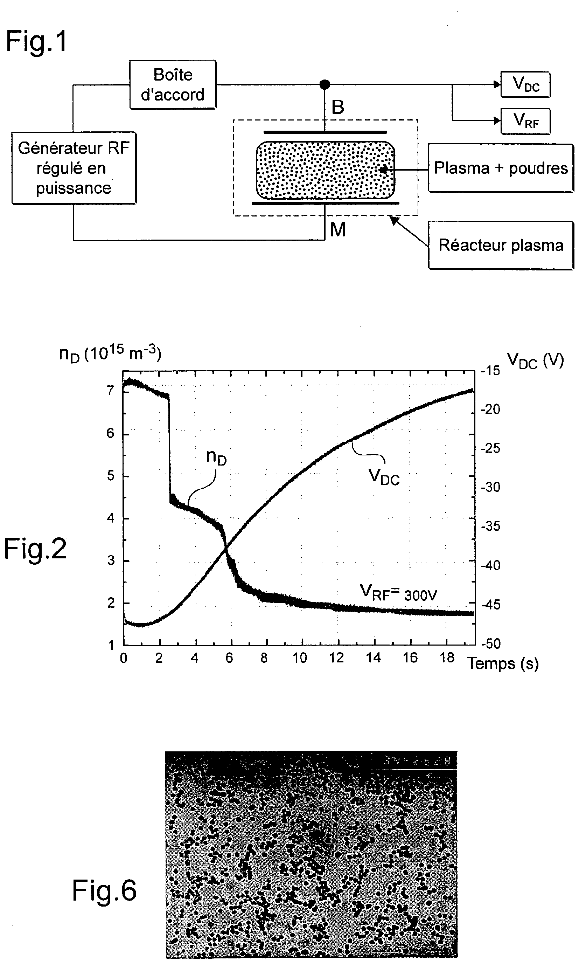

Selon l'invention et en référence à la figure 1, le plasma est initié dans un réacteur plasma au moyen d'une décharge capacitive radiofréquence RF asservie en puissance. Un couplage capacitif à un générateur RF pour délivrer une tension d'excitaton radiofréquence d'amplitude $V_{RF}$ est obtenu grâce à une boîte d'accord en L connue en soi. Lorsque le plasma s'établit entre les électrodes, il apparaît naturellement une tension d'autopolarisation $V_{DC}$ au niveau de l'électrode B qui reçoit la tension d'excitation. L'électrode M est en général reliée à la masse.

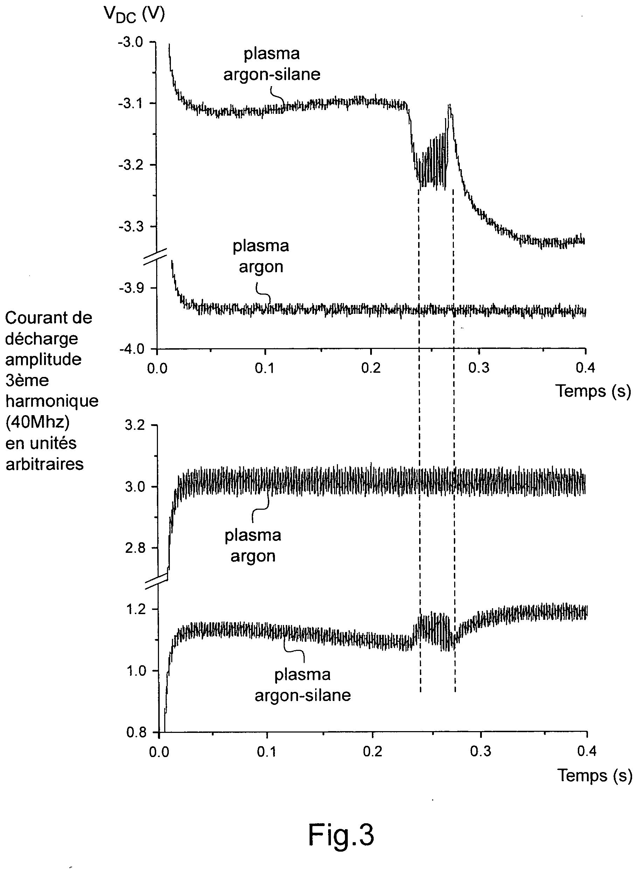

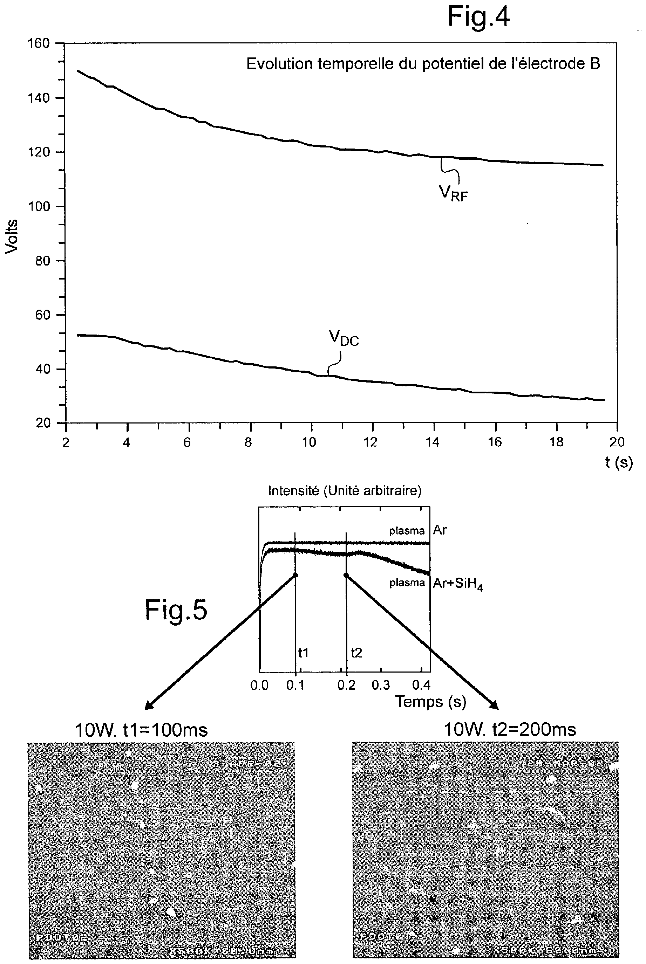

Lorsque des particules de poudre apparaissent dans le plasma (par croissance ou bien par injection), les caractéristiques de ce dernier changent. Parmi ces changements, on remarque une chute de la densité électronique, une élévation de la température électronique ainsi qu'une variation de $V_{DC}$ (fig. 2 et 3) et de $V_{RF}$ (fig. 4).

La validation de cette méthode de détection des poudres à différentes phases de leur croissance a été réalisée grâce au dépôt de nanopoudres sur un substrat de silice (SiO2). Il s'agit de la nucléation et de la croissance de poudres en phase gazeuse dans un plasma. La nucléation et la croissance résultent de réactions classiques qui impliquent des espèces réactives, des radicaux (fragments de molécules) qui sont produits par la dissociation de molécules réactives telles que le silane ou le méthane, etc..., par des produits de gravure par plasma, par exemple SiFx (avec x = 1, 2, ou 3), ou bien encore les produits de pulvérisation par plasma.

Ces mécanismes ont été étudiés et résumés dans la publication suivante : André Bouchoule et collaborateurs dans Pure and Appl. Chem. Vol 68 n° 5, pages 1121 - 1126 (1996).

La figure 5 montre que l'on peut contrôler la synthèse des poudres avant et après le démarrage au temps $t_2$ d'une phase d'agglomération des nanocristallites.

Ces courbes montrent la présence de particules solides au sein du plasma. D'autre part, une étude de l'intercorrélation des effets obtenus a permis de mettre au point une méthode de mesure de la taille des particules et/ou de la densité particulaire d'un échantillon monotaille (ou monodispersé) piégé au sein du plasma. Cette méthode est relativement simple puisqu'elle permet d'analyser l'échantillon à partir de la mesure des modifications de la tension d'excitation et de la tension d'autopolarisation $V_{DC}$ qui sont induites par l'apparition de la poudre au sein du plasma.

Il est ici précisé que la valeur de $V_{RF}$ qui est prise en compte est l'amplitude de la tension d'excitation RF proprement dite, et que la valeur de $V_{DC}$ qui est prise en compte est la valeur moyenne du potentiel de l'électrode B par rapport à la masse.

Plage de mesure :

Taille : détermination du rayon surfacique moyen $r_D$ des particules ou des agglomérats d'une poudre dans une gamme s'étendant de quelques nanomètres de diamètre à plusieurs microns (par exemple 2 nm à 10 $\mu$m).

Densité particulaire : la plage de densité particulaire dépend de la taille des particules de la poudre constituant l'échantillon. D'après les expérimentations, pour lesquelles la précision de mesure de $V_{DC}$ est de 10 mV, la plus petite masse analysable pour une particule de poudre de carbone est inférieure à 1 $\mu$g. Ce seuil correspond à $10^8$ particules par cm$^3$ de 10 nm de rayon ou à $10^5$ particules par cm$^3$ de 1 $\mu$m de rayon. Il est possible d'abaisser ce seuil en utilisant une électronique de mesure plus sensible car les chiffres indiqués ci-dessus sont obtenus à partir d'une variation minimale détectable de 10 mV sur $V_{DC}$.

Démonstration de la méthode :

D'après la publication de E. Kawamura [E. Kawamura, V. Vahedi, M. A. Lieberman and C. K. Birdsall, intitulé "Ion energy destributions in rf sheaths ; review, analysis and simulation", publiée dans "Plasma source Sci. Technol. 8, R45-R64, 1999", IOP Publishing Ltd)] et qui concerne seulement le cas d'un plasma conventionnel, c'est-à-dire ne comportant pas de particules de poudre, on a à un instant t :

$$V_{DC} = V_{RF} \cos\left(\frac{\pi}{1+\delta}\right) \qquad\qquad \text{Eq. 1}$$

soit

$$\delta = \frac{A_B}{A_M} = \frac{\pi}{\arccos\left(\dfrac{V_{DC}}{V_{RF}}\right)} - 1 \qquad \text{Eq. 2}$$

Ainsi, les surfaces effectives d'échange de charges entre le plasma et les électrodes peuvent être exprimées par :

$$A_B = \alpha\left(\pi - \arccos\left(\frac{V_{DC}}{V_{RF}}\right)\right) \qquad \text{Eq. 3}$$

$$A_M = \alpha\left(\arccos\left(\frac{V_{DC}}{V_{RF}}\right)\right) \qquad \text{Eq. 4}$$

Où $\alpha$ est la surface caractéristique de la décharge.

Par conséquent, on constate que :

$$\frac{dA_B}{d\left(\dfrac{V_{DC}}{V_{RF}}\right)} = \frac{\alpha}{\sqrt{1 - \left(\dfrac{V_{DC}}{V_{RF}}\right)^2}} = -\frac{dA_M}{d\left(\dfrac{V_{DC}}{V_{RF}}\right)} \quad \text{d'où} \quad \Delta A_B = -\Delta A_M \qquad \text{Eq. 5}$$

Autrement dit, la variation de la surface effective d'échange de charges entre le plasma et une des deux électrodes est compensée par la variation de la surface d'échange de charges entre le plasma et l'autre électrode.

A présent, considérons dans le cadre de la présente invention $\delta_0$ et $\delta_1$, comme étant respectivement le rapport

$\dfrac{A_{B0}}{A_{M0}}$ en l'absence de poudre et $\dfrac{A_B}{A_M}$ en présence de poudre

et avec $A_B = A_{B0} + \Delta A_B$ et $A_M = A_{M0} + \Delta A_M$.

On a :

$$\delta_1 = \frac{A_{B0} + \Delta A_B}{A_{M0} - \Delta A_B} = \delta_0 \times \frac{1 + \dfrac{\Delta A_B}{A_{B0}}}{1 - \dfrac{\Delta A_B}{A_{M0}}} \qquad \text{Eq. 6}$$

La variation de la surface de l'électrode B est liée à la surface cumulée des poudres piégées dans le plasma. Ainsi :

$$\Delta A_B \approx 4\pi \ V \int_{r\min}^{r\max} r_D^2 \, n_D(r_D) dr_D \qquad \text{Eq. 7}$$

$r_{min}$ et $r_{max}$ désignant les valeurs minimales et maximales du rayon $r_D$ des particules présentes dans la poudre.

Dans le cas d'un échantillon monodispersé comportant des particules sphériques ayant toute la même taille (comme représenté la figure 6), on a :

$$\Delta A_B = 4\pi \ V \ r_D^2 \ n_D \qquad \text{Eq. 8}$$

D'autre part, la présence des particules de poudre au sein du plasma modifie l'expression de la quasi neutralité électrique de ce dernier. Par conséquent, on a :

$$n_i = n_e + Z_D n_D \qquad \text{Eq. 9}$$

En considérant les particules ou agglomérats de poudre immergés dans le plasma comme étant des capacités sphériques dont une armature est au potentiel flottant (le potentiel à la surface d'une particule) et l'autre est au potentiel du plasma, on peut exprimer le nombre $Z_D$ d'électrons attachés à chaque particule de poudre en fonction du rayon de cette dernière et de la différence (moyenne) de potentiel $|\Phi|$ entre le plasma et chaque particule de poudre (théorème de Gauss) :

$$Z_D = \frac{4\pi\varepsilon_0}{q} r_D |\Phi| \qquad \text{Eq. 10}$$

A partir des deux équations précédentes, on peut exprimer le produit 'taille x densité' de l'échantillon :

$$r_D \ n_D = \frac{q(n_i - n_e)}{4\pi \ \varepsilon_0 |\Phi|} \qquad \text{Eq. 11}$$

En associant les équations 8 et 11 on obtient :

$$n_D = \frac{q(n_i - n_e)}{4\pi\varepsilon_0 |\Phi| r_D} \qquad \text{Eq. 12}$$

$$r_D = \frac{\Delta A_B \varepsilon_0 |\Phi|}{q(n_i - n_e) \times V} \qquad \text{Eq. 13}$$

D'après ces équations, nous disposons d'une méthode permettant de déterminer le rayon surfacique moyen $r_D$ ainsi que la densité particulaire $n_D$ d'un échantillon de poudres piégées dans le plasma. Elle est cependant assez difficile à mettre en oeuvre car elle nécessite la connaissance des densités électronique et ionique ainsi que de la température électronique moyenne, ce paramètre ayant une grande influence sur la détermination de $|\Phi|$.

Ces paramètres évoluent lors de la croissance de nanopoudres de silicium ou de carbone dans des plasma froids basse pression.

A partir de ces mesures, comme on peut le remarquer sur la courbe ci-dessous, on a :

$$\frac{|\Phi|}{n_i - n_e} = \frac{C}{(T_e - T_e(0))^n} \qquad \text{Eq. 14}$$

Avec $T_e(0)$ la température électronique du plasma sans aucune poudre, et Te la température électronique à l'instant t en présence de poudre.

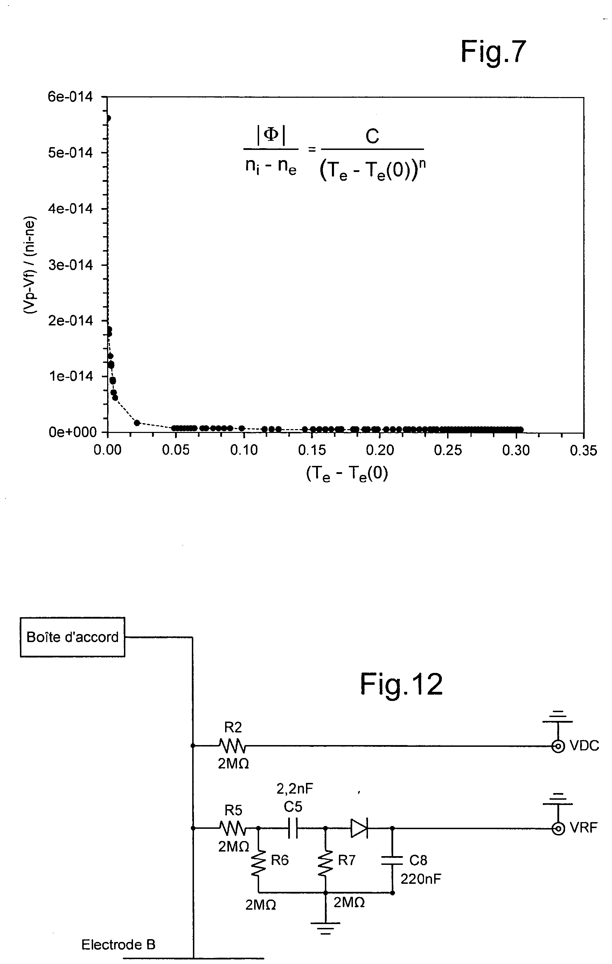

La Figure 7 illustre la relation entre $|\Phi|$, $n_i - n_e$ et la variation de la température électronique en présence de poudre

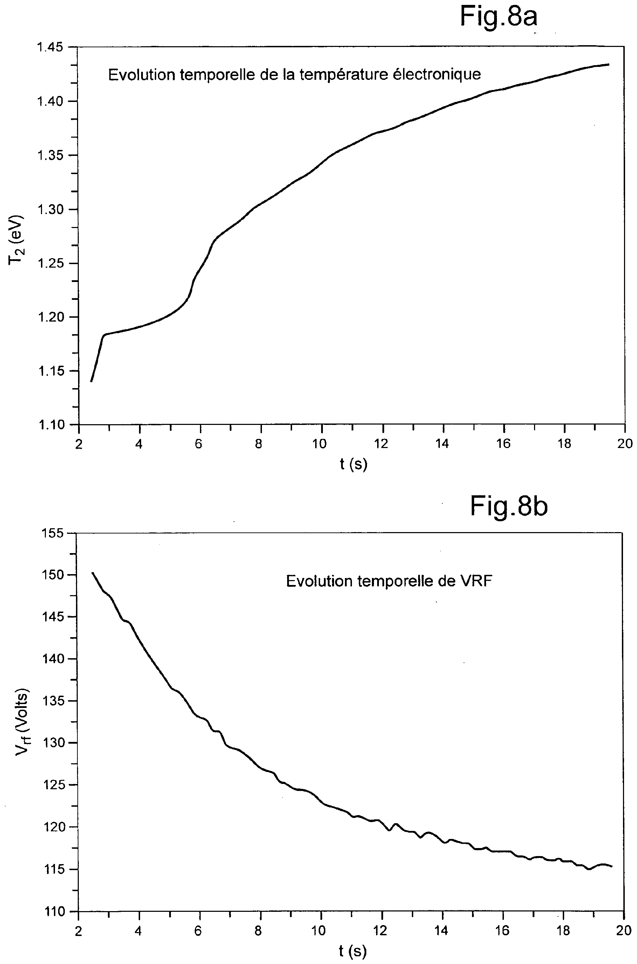

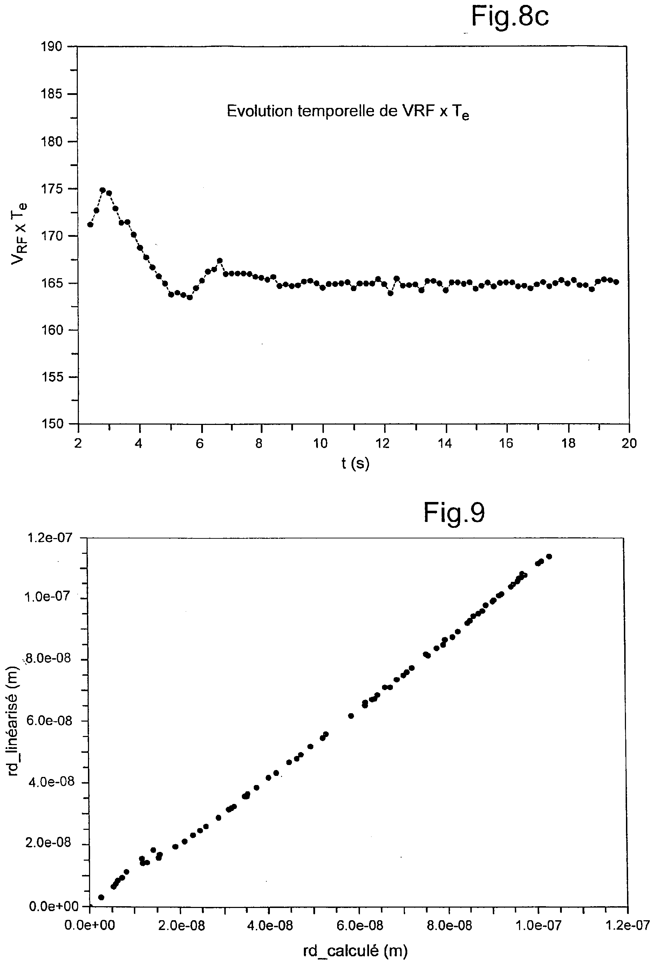

De plus, comme on le voit sur les figures 8a à 8c dans lesquelles les figures 8a et 8b représentent l'évolution respective de Te et de $V_{RF}$ et la figure 8c le produit $V_{RF}$ x Te, on a, en raison de l'asservissement en puissance du générateur RF : $V_{RF} \times T_e = C^{ste}$ lors de la croissance de nanopoudres, Te désignant la température électronique à l'instant t et Te(0) la température électronique en l'absence de poudre (instant 0).

On aura donc :

$$T_e - T_e(0) = D\left(\frac{1}{V_{RF}} - \frac{1}{V_{RF}(0)}\right)$$ Eq. 15

$$\text{avec } D = C^{ste}$$

Au final, on trouve :

$$n_D = \frac{q^2}{4\pi\varepsilon_0^2} \frac{D^{2n}\left(\frac{1}{V_{RF}} - \frac{1}{V_{RF}(0)}\right)^{2n}}{C^2} \frac{V}{\Delta A_B} = \frac{1}{4\pi K^2 V \Delta A_B} \times \left(\frac{1}{V_{RF}} - \frac{1}{V_{RF}(0)}\right)^{2n}$$ Eq. 16

$$r_D = \frac{\Delta A_B}{V} \frac{\varepsilon_0}{q} \frac{C}{D^n\left(\frac{1}{V_{RF}} - \frac{1}{V_{RF}(0)}\right)^n} = K \frac{\Delta A_B}{\left(\frac{1}{V_{RF}} - \frac{1}{V_{RF}(0)}\right)^n}$$ Eq. 17

$$K = \frac{\varepsilon_0 C}{q V D^n}, \quad \Delta A_B(t) = \frac{\frac{\delta(t)}{\delta(0)} - 1}{\frac{1}{A_{M0}} + \frac{1}{A_B 0}} \quad \delta(t) = \frac{\pi}{arccos\left(\frac{V_{DC}}{V_{RF}}\right)} - 1$$ et

Avec :

$V_{DC}$ et $V_{RF}$ désignant la valeur de la tension d'autopolarisation et la tension d'excitation à l'instant t, alors que $V_{DC(0)}$ et $V_{RF(0)}$ expriment ces deux valeurs en l'absence de poudre (instant o).

Ainsi, il y a deux constantes à étalonner : $n$ et $K$. Cela peut être fait en analysant différents échantillons calibrés de poudre comportant des particules de diamètre connu. On remarque également que l'incertitude sur la densité particulaire est liée à l'estimation du volume V du plasma.

Etalonnage :

Dans un plasma Ar + $CH_4$ on fait croître des particules de nanopoudre de carbone ayant une taille de particules connue dont la valeur $r_D$ est connue et est comprise entre 10 et 100 nm de diamètre ou bien on utilise des poudres dont le diamètre des particules est connu. Connaissant $V_{RF}(r_D)$ et $V_{DC}(r_D)$ on peut tracer $r_D = f(\Delta A_B, \Delta V_{RF}^{-1}) = \Delta A_B / (1/V_{RF} - 1/V_{RF(0)})$.

Ensuite, à l'aide d'une régression linéaire, on peut déterminer $n$ et $K$. Cette régression linéaire donne des valeurs calculées de $r_D$ notées $r_{D-fit}$.

On trouve :

$$K = 6,4.10^{-6} \text{ et } n = 0,307 \text{ et } r_{D-fit} = K \frac{\Delta A_B}{\left(\frac{1}{V_{RF}} - \frac{1}{V_{RF}(0)}\right)^n}$$

Pour vérifier la relation, on peut tracer $r_D = f(r_{D\_fit})$, c'est-à-dire la relation entre la valeur $r_D$ connue et la valeur calculée selon l'invention, afin de constater qu'il s'agit bien d'une relation linéaire entre le rayon calculé par cette méthode et le rayon linéarisé obtenu à partir de $V_{DC}$ (voir figure 9), ce qui valide les valeurs n et K que l'on peur utiliser pour déterminer $r_D$ et/ou $n_D$ pour une poudre qui est introduite entre les électrodes et dont on ne connaît pas les paramètres.

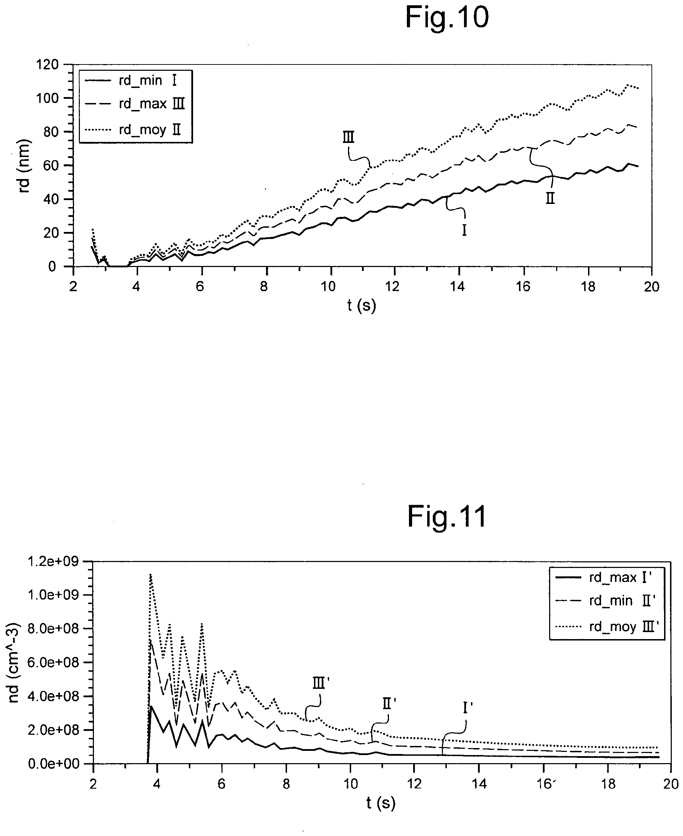

Les figures 10 et 11 montrent l'évolution simultanée de l'évolution du rayon $r_D$ et de la densité particulaire $n_D$ d'une poudre au cours d'une période de croissance de 20 secondes au cours de laquelle se forment des agglomérats.

Le procédé selon l'invention permet de tracer de telles courbes à partir des valeurs instantanées des tensions $V_{RF}$ et $V_{DC}$, mesurées à partir de l'instant initial (avant introduction de la poudre).

$r_D$ dépend de K, de n et de la tension d'excitation et de $\Delta_{AB}$. K et n sont déterminés par l'étalonnage et $\Delta_{AB}$ dépend des tensions $V_{DC}$ et $V_{RF}$

$n_D$ dépend en outre du volume V du plasma dont la valeur est estimée sensiblement égale au volume disponible entre les deux électrodes.

La figure 12 est un mode de réalisation d'un circuit de mesure du potentiel $V_{RF}$ et du potentiel d'autopolarisation $V_{DC}$ qui se raccorde à l'électrode B en sortie de la boîte d'accord. Ce circuit est conçu pour présenter une impédance élevée (en pratique > 500 k($\Omega$ ou de préférence 1 M$\Omega$) qui ne perturbe pas la formation du plasma. Elle permet un raccordement sur tout dispositif existant ayant ou non un dispositif de mesure incorporé. En effet, les dispositifs de mesure actuellement utilisés dans les installations industrielles manquent de précision, et ne conviennent en général pas au procédé selon l'nvention

- Mesure de $V_{DC}$ : la tension d'autopolarisation est mesurée avec un filtre passe-bas de type RC. Le condensateur n'est pas représenté sur le schéma car il s'agit de la capacité parasite du câble coaxial de type BNC (-30 pF) reliant la sortie $V_{DC}$ à un oscilloscope, ou à un dispositif de mesure de la tension.
- Mesure de $V_{RF}$ : L'amplitude de la tension appliquée à l'électrode B est mesurée avec un détecteur de crête utilisant une diode rapide de type Schottky couplée à un condensateur de mesure C8. On place un filtre passe-haut (R7, C5) avant cette diode pour supprimer la composante continue du signal. Un pont diviseur de tension (R5, R6) qui peut être placé avant ce filtre a pour but de protéger la diode des surtensions.
- D'autre part, il est important que ces deux circuits de mesure présentent une impédance d'entrée élevée pour ne pas perturber le potentiel de l'électrode B. Il faut également prendre soin de choisir une impédance d'entrée élevée (1 M$\Omega$) pour les voies de l'oscilloscope reliées au circuit.

Le circuit de mesure peut être associé à un module de calcul du rayon surfacique $r_D$ et/ou de la densité particulaire $n_D$, conformément aux équations ci-dessus.

Le procédé selon l'invention peut s'appliquer à l'apparition et à la croissance de nanopoudres dans un plasma basse pression aussi bien qu'à des nanopoudres injectées ou aspirées. L'invention s'applique en particulier :

- au contrôle de la contamination particulaire des réacteurs plasma utilisés en microélectronique ; le dispositif peut être ainsi utilisé pour un dispositif scellé, un détecteur pouvant être disposé in situ dans le réacteur plasma;
- au contrôle des salles blanches dans lesquelles sont installés des réacteurs et autres équipements ce qui permet de protéger le personnel. A cet effet, on aspire la poudre pour qu'elle parvienne entre les électrodes et le plasma est obtenu dans l'air;
- à un contrôle d'environnement dans des laboratoires ou des ateliers, avec un plasma formé dans l'air.

**Revendications**

1. Procédé de détermination du rayon surfacique moyen $r_D$ et/ou de la densité $n_D$ des particules d'une poudre dans un échantillon en lévitation dans un plasma de volume V formé entre une première électrode alimentée par une tension radiofréquence et une deuxième électrode portée à une tension fixe, notamment de masse, **caractérisé en ce que** :

$$n_D = \frac{1}{4\pi K^2 V \Delta A_B} \times \left( \frac{1}{V_{RF}} - \frac{1}{V_{RF(0)}} \right)^{2n}$$

$$r_D = K \frac{\Delta A_B}{\left( \dfrac{1}{V_{RF}} - \dfrac{1}{V_{RF(0)}} \right)^n}$$

$$K = \frac{\varepsilon_0 C}{q\,V\,D^n}, \quad \Delta A_B = \frac{\dfrac{\delta(t)}{\delta(0)} - 1}{\dfrac{1}{A_{M0}} + \dfrac{1}{A_{B0}}} \qquad\qquad \delta(t) = \frac{\pi}{arccos\left(\dfrac{V_{DC}}{V_{RF}}\right)} - 1$$

Avec : et

$$\delta(0) = \frac{\pi}{arccos\left(\dfrac{V_{DC(0)}}{V_{RF(0)}}\right)} - 1$$

$V_{RF}$ désigne l'amplitude à l'instant de mesure t de la tension radiofréquence RF alimentant la première électrode lorsque la poudre est présente dans le plasma, où l'instant t = 0 correspond à l'absence de poudre dans le plasma, $V_{RF(0)}$ désigne l'amplitude de ladite tension radiofréquence alimentant la première électrode en l'absence de poudre dans le plasma,

$V_{DC}$ désignant la tension d'autopolarisation de la première électrode à l'instant t lorsque la poudre est présente dans le plasma,

$V_{DC(0)}$ désignant la tension d'autopolarisation de la première électrode en l'absence de poudre dans le plasma, $\Delta A_B$ désignant la variation de surface de la deuxième électrode en présence de poudre à l'instant t par rapport à une situation en l'absence de poudre, $A_{B0}$ et $A_{M0}$ désignant la surface effective des électrodes en l'absence de poudre,

et les valeurs de n et de K étant déterminées par étalonnage en traçant une courbe donnant $r_D$ en fonction de $\Delta A_B$ et de $V_{RF}$ à partir de données expérimentales obtenues à partir de poudres ayant un diamètre de particules connu en mesurant $V_{RF}$, $V_{RF(0)}$, $V_{DC}$, et $V_{DC(0)}$ et en réalisant une régression sur ladite courbe.

2. Procédé selon la revendication 1, **caractérisé en ce que** le plasma est un plasma électropositif.

3. Procédé selon la revendication 1, **caractérisé en ce que** le plasma est un plasma d'air.

4. Procédé selon la revendication 3, **caractérisé en ce que** la première et la deuxième électrodes sont disposés dans une cellule pourvue d'un moyen d'aspiration.

5. Dispositif pour la mise en oeuvre du procédé selon une des revendications précédentes, comportant :

   - un générateur radio fréquence alimentant une première et une deuxième électrodes pour générer un dit plasma dans un volume V, compris entre lesdites électrodes,

   **caractérisé en ce que** le dispositif comporte en outre :

   - un dispositif de mesure de la tension radiofréquence $V_{RF}$ et de la tension d'autopolarisation $V_{DC}$
   - un modèle de calcul du rayon surfacique $r_D$ et/ou de la densité particulaire $n_D$, conformément aux équations de la revendication 1.

6. Dispositif selon la revendication 5, **caractérisé en ce que** le dispositif de mesure de la tension radiofréquence $V_{RF}$ comporte un filtre passe-haut (R7, C5) disposé en amont d'une diode Schottky, formant un détecteur de crète.

7. Dispositif selon la revendication 6, **caractérisé en ce qu'**il comporte un pont diviseur (R5, R6) en amont du filtre passe haut.

8. Dispositif selon une des revendications 5 à 7, **caractérisé en ce que** le dispositif de mesure de la tension d'auto-polarisation $V_{DC}$ comporte un filtre passe-bas.

9. Dispositif selon la revendication 8, **caractérisé en ce que** le filtre passe-bas présente une résistance (R2) et un condensateur constitué par la capacité d'un câble en série avec ladite résistance (R2).

**Patentansprüche**

1. Verfahren zur Bestimmung des mittleren Oberflächenradius $r_D$ und/oder der Dichte $n_D$ der Partikel eines Pulvers in einer Probe, welche in einem Plasma mit Volumen V in der Schwebe gehalten wird, welches zwischen einer ersten Elektrode, gespeist durch eine Hochfrequenzspannung, und einer zweiten Elektrode, welche auf eine feste Spannung gebracht wird, insbesondere eine Massenspannung, gebildet ist, **dadurch gekennzeichnet, dass**:

$$n_D = \frac{1}{4\pi K^2 V \Delta A_B} \times \left( \frac{1}{V_{RF}} - \frac{1}{V_{RF(0)}} \right)^{2n}$$

$$r_D = K \frac{\Delta A_B}{\left( \dfrac{1}{V_{RF}} - \dfrac{1}{V_{RF(0)}} \right)^n}$$

$$K = \frac{\varepsilon_0 C}{q \, V \, D^n}, \quad \Delta A_B = \frac{\dfrac{\delta(t)}{\delta(0)} - 1}{\dfrac{1}{A_{M0}} + \dfrac{1}{A_{B0}}}, \quad \delta(t) = \frac{\pi}{arccos\left(\dfrac{V_{DC}}{V_{RF}}\right)} - 1$$

wobei:

$$\delta(0) = \frac{\pi}{arccos\left(\dfrac{V_{DC(0)}}{V_{RF(0)}}\right)} - 1$$

und

wobei $V_{RF}$ die Amplitude zum Messzeitpunkt t der Hochfrequenzspannung RF bezeichnet, welche die erste Elektrode speist, wenn das Pulver im Plasma vorhanden ist, wobei der Zeitpunkt t = 0 der Abwesenheit von Pulver im Plasma entspricht,

$V_{RF(0)}$ die Amplitude der Hochfrequenzspannung bezeichnet, welche die erste Elektrode bei Abwesenheit von Pulver im Plasma speist,

$V_{DC}$ die Selbstpolarisierungsspannung der ersten Elektrode zum Zeitpunkt t bezeichnet, wenn das Pulver im Plasma vorhanden ist,

$V_{DC(0)}$ die Selbstpolarisierungsspannung der ersten Elektrode bei Abwesenheit von Pulver im Plasma bezeichnet,

$\Delta A_B$ die Schwankung der Oberfläche der zweiten Elektrode bei Vorhandensein von Pulver zum Zeitpunkt t im Vergleich zu einer Situation bei Abwesenheit von Pulver bezeichnet, $A_{B0}$ und $A_{M0}$ die effektive Oberfläche der Elektroden bei Abwesenheit von Pulver bezeichnet,

und die Werte von n und von K durch Kalibrieren bestimmt werden, durch Plotten einer Kurve, welche $r_D$ als Funktion von $\Delta A_B$ und von $V_{RF}$ anhand experimenteller Daten angibt, welche anhand von Pulvern erzielt wurden, welche einen bekannten Partikeldurchmesser besitzen, anhand der Messung von $V_{RF}$, $V_{RF(0)}$, $V_{DC}$, und $V_{DC(0)}$ und der Vornahme einer Regression der Kurve.

2. Verfahren nach Anspruch 1, **dadurch gekennzeichnet, dass** das Plasma ein elektropositives Plasma ist.

3. Verfahren nach Anspruch 1, **dadurch gekennzeichnet, dass** das Plasma ein Luftplasma ist.

4. Verfahren nach Anspruch 3, **dadurch gekennzeichnet, dass** die erste und die zweite Elektrode in einer Zelle angeordnet sind, welche mit einem Absaugmittel versehen ist.

5. Vorrichtung zur Umsetzung des Verfahrens nach einem der vorhergehenden Ansprüche, Folgendes beinhaltend:

- einen Hochfrequenzgenerator, welcher eine erste und eine zweite Elektrode speist, um ein solches Plasma in einem Volumen V, welches zwischen den Elektroden enthalten ist, zu erzeugen,

**dadurch gekennzeichnet, dass** die Vorrichtung zudem Folgendes beinhaltet:

- eine Messvorrichtung der Hochfrequenzspannung $V_{RF}$ und der Selbstpolarisierungsspannung $V_{DC}$
- ein Rechenmodell des Oberflächenradius $r_D$ und/oder der Partikeldichte $n_D$ gemäß den Gleichungen von Anspruch 1.

6. Vorrichtung nach Anspruch 5, **dadurch gekennzeichnet, dass** die Messvorrichtung der Hochfrequenzspannung $V_{RF}$ einen Hochpassfilter (R7, C5) beinhaltet, welcher im vorgelagerten Bereich einer Schottky-Diode angeordnet ist, welche einen Spitzendetektor bildet.

7. Vorrichtung nach Anspruch 6, **dadurch gekennzeichnet, dass** sie eine Teilerbrücke (R5, R6) im vorgelagerten Bereich des Hochpassfilters beinhaltet.

8. Vorrichtung nach einem der Ansprüche 5 bis 7, **dadurch gekennzeichnet, dass** die Messvorrichtung der Selbstpolarisierungsspannung $V_{DC}$ einen Tiefpassfilter beinhaltet.

9. Vorrichtung nach Anspruch 8, **dadurch gekennzeichnet, dass** der Tiefpassfilter einen Widerstand (R2) und einen durch die Kapazität eines in Reihe mit dem Widerstand (R2) geschalteten Kabels gebildeten Kondensator beinhaltet.

**Claims**

1. Method of determining the mean surface radius $r_D$ and/or the particle density $n_D$ of a powder in a sample levitated in a plasma of volume V formed between a first electrode supplied with a radiofrequency voltage and a second electrode carried at a constant voltage, notably ground, **characterised in that**:

$$n_D = \frac{1}{4\pi K^2 V \Delta A_B} \times \left( \frac{1}{V_{RF}} - \frac{1}{V_{RF(0)}} \right)^{2n}$$

$$r_D = K \frac{\Delta A_B}{\left( \dfrac{1}{V_{RF}} - \dfrac{1}{V_{RF(0)}} \right)^{n}}$$

$$K = \frac{\varepsilon_0 C}{q\, V\, D^n}, \quad \Delta A_B = \frac{\dfrac{\delta(t)}{\delta(0)} - 1}{\dfrac{1}{A_{M0}} + \dfrac{1}{A_{B0}}}, \quad \delta(t) = \frac{\pi}{arccos\left( \dfrac{V_{DC}}{V_{RF}} \right)} - 1 \qquad \delta(0) = \frac{\pi}{arccos\left( \dfrac{V_{DC(0)}}{V_{RF(0)}} \right)} - 1$$

with:                                                                                          and

$V_{RF}$ designates the amplitude at the measurement instant t of the radiofrequency RF voltage supplying the first electrode when the powder is present in the plasma, where the instant t = 0 corresponds to the absence of powder in the plasma,

$V_{RF(0)}$ designates the amplitude of said radiofrequency voltage supplying the first electrode in the absence of powder in the plasma,

$V_{DC}$ designating the self-bias voltage of the first electrode at the instant t when the powder is present in the plasma,

$V_{DC(0)}$ designating the self-bias voltage of the first electrode in the absence of powder in the plasma,

$\Delta A_B$ designating the surface variation of the second electrode in the presence of powder at the instant t relative to a situation in the absence of powder, $A_{B0}$ and $A_{M0}$ designating the effective surface of the electrodes in the absence of powder,

and the values of n and K being determined by calibration by plotting a curve showing $r_D$ as a function of $\Delta A_B$ and $V_{RF}$ based on experimental data obtained on the basis of the powders having a known particle diameter by measuring $V_{RF}$, $V_{RF(0)}$, $V_{DC}$, and $V_{DC(0)}$ and by performing regression on said curve.

**2.** Method according to claim 1, **characterised in that** the plasma is an electropositive plasma.

**3.** Method according to claim 1, **characterised in that** the plasma is an air plasma.

**4.** Method according to claim 3, **characterised in that** the first and second electrodes are arranged in a cell provided with a suction means.

**5.** Device for implementing the method according to one of the previous claims, comprising:

 - a radiofrequency generator supplying a first and a second electrode to generate a said plasma in a volume V, comprised between said electrodes,

**characterised in that** the device further comprises:

 - a device for measuring the radiofrequency voltage $V_{RF}$ and the self-bias voltage $V_{DC}$
 - a model for calculating the surface radius $r_D$ and/or the particle density $n_D$, in accordance with the equations of claim 1.

**6.** Device according to claim 5, **characterised in that** the device for measuring the radiofrequency voltage $V_{RF}$ comprises a high-pass filter (R7, C5) arranged upstream of a Schottky diode, forming a peak detector.

**7.** Device according to claim 6, **characterised in that** it comprises a divider bridge (R5, R6) upstream of the high-pass filter.

**8.** Device according to one of claims 5 to 7, **characterised in that** the device for measuring the self-bias voltage $V_{DC}$ comprises a low-pass filter.

**9.** Device according to claim 8, **characterised in that** the low-pass filter has a resistor (R2) and a capacitator composed of the capacitance of a cable in series with said resistor (R2).

## Fig.1

## Fig.2

## Fig.6

Fig.3

## Fig.4

Evolution temporelle du potentiel de l'électrode B

$V_{RF}$

$V_{DC}$

Volts

t (s)

Intensité (Unité arbitraire)

plasma Ar

plasma Ar+SiH$_4$

t1    t2

Temps (s)

## Fig.5

10W. t1=100ms

10W. t2=200ms

## Fig.7

$$\frac{|\Phi|}{n_i - n_e} = \frac{C}{(T_e - T_e(0))^n}$$

## Fig.12

## Fig.8a

Evolution temporelle de la température électronique

## Fig.8b

Evolution temporelle de VRF

## Fig.8c

Evolution temporelle de VRF x $T_e$

## Fig.9

# Fig.10

# Fig.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M. C. ROCO.** International perspective on government nanotechnology funding in 2005. *J. Nanopart. Res.,* 2005, vol. 7 (6), 707-712
- *Technology Review, www.technologyreview.fr/nano-tech/?id=196*
- **OBERDÖRSTER G ; OBERDÖRSTER E ; OBERDÖRSTER J.** Concepts of nanoparticle dose metric and response metric. *Environ Health Perspect,* Juin 2007, vol. 115 (6), A290
- **CHIU-WING LAM ; JOHN T. JAMES ; RICHARD MCCLUSKEY ; ROBERT L. HUNTER.** *Toxicological Sciences,* 2004, vol. 77, 126-134
- **L. BOUFENDI.** Détection of particles of less than 5 nm in diameter formed in an argon-silane capacitivily coupled radio-frequency discharge. *Applied physics letters,* 24 Décembre 2001, vol. 79 (26
- **ANDRÉ BOUCHOULE.** *Pure and Appl. Chem.,* 1996, vol. 68 (5), 1121-1126
- Ion energy destributions in rf sheaths ; review, analysis and simulation. **E. KAWAMURA ; V. VAHEDI ; M. A. LIEBERMAN ; C. K. BIRDSALL.** Plasma source Sci. Technol. IOP Publishing Ltd, 1999, vol. 8, R45-R64